# EUROPEAN PATENT APPLICATION

(11) **EP 4 750 231 A1**
(43) Date of publication of application: **27.05.2026**
(21) Application number: 24884105.8
(22) Date of filing: 09.08.2024
(51) Int. Cl.: H05K 1/18, H04M 1/02

(54) **FLEXIBLE PRINTED CIRCUIT AND ELECTRONIC DEVICE**

(30) Priority: 01.11.2023 CN 202311444392
(71) Applicant: Honor Device Co., Ltd., Shenzhen, Guangdong 518040 (CN)
(72) Inventor: WANG, Yu, Shenzhen, Guangdong 518040 (CN); ZHOU, Guotong, Shenzhen, Guangdong 518040 (CN); LI, Jianhui, Shenzhen, Guangdong 518040 (CN); YAN, Bin, Shenzhen, Guangdong 518040 (CN)
(74) Representative: Henselmann, Alexander Gerhard
(86) International application number: PCT/CN2024/110997
(87) International publication number: WO 2025/092098

(57) **Abstract**

This application relates to the field of electronic product technologies, and in particular, to a flexible printed circuit and an electronic device. The flexible printed circuit is configured to connect to a USB interface and a mainboard in the electronic device. The flexible printed circuit includes two flexible circuit boards, that is, a first flexible circuit board and a second flexible circuit board, which are detachably connected. The first flexible circuit board is arranged on a rear side of a battery and is connected to the USB interface. The second flexible circuit board is arranged on a front side of the battery and is connected to the mainboard. When the USB interface needs to be detached, the first flexible circuit board can be seen by opening a cover plate on a rear side of the electronic device. Because the first flexible circuit board is detachably connected to the second flexible circuit board, the connection between the first flexible circuit board and the second flexible circuit board may be conveniently released, so that the first flexible circuit board is removed, and then subsequent processing is performed on the USB interface. In this way, there is no need to detach the battery, and steps of detaching the USB interface are simplified, so that the detaching complexity is reduced and there is no need to reinstall the battery, thereby reducing assembly difficulty and repair costs.

## Description

This application claims priority to Chinese Patent Application No. 202311444392.6, filed with the China National Intellectual Property Administration on November 1, 2023 and entitled "FLEXIBLE PRINTED CIRCUIT AND ELECTRONIC DEVICE", which is incorporated herein by reference in its entirety.

### TECHNICAL FIELD

This application relates to the field of electronic product technologies, and in particular, to a flexible printed circuit and an electronic device.

### BACKGROUND

A universal serial bus (universal serial bus, USB) interface is a universal computer interface, and has become one of main manners for data transmission and power supply between modem electronic devices. Almost each electronic device is equipped with a USB interface, which is configured to connect to a charger, a data cable, a headset, or the like.

In the electronic device, the USB interface needs to be electrically connected to a mainboard by using a flexible printed circuit (flexible printed circuit, FPC), to implement a function of connecting to a charger, a data cable, a headset, or the like.

Currently, in the electronic device, the FPC which is configured to connect to the USB interface and the mainboard is generally arranged on one side of a battery facing a screen. Therefore, to detach the USB interface, the battery needs to be detached first. As a result, the detaching process is relatively complex, and the battery needs to be reinstalled, increasing difficulty of assembling.

### SUMMARY

Embodiments of this application provide a flexible printed circuit and an electronic device, to simplify a process of detaching a USB interface, and reduce assembly difficulty and repair costs.

According to a first aspect, an embodiment of this application provides a flexible printed circuit, including a first flexible circuit board and a second flexible circuit board, where a first end of the first flexible circuit board is configured to connect to a universal serial bus interface of an electronic device in which the flexible printed circuit is located, where the first flexible circuit board is arranged on one side of a battery of the electronic device facing away from a screen of the electronic device, and a second end of the first flexible circuit board is detachably connected to a first end of the second flexible circuit board; and a second end of the second flexible circuit board is connected to a mainboard of the electronic device, where the second flexible circuit board is arranged on one side of the battery facing the screen.

It may be understood that the flexible printed circuit provided in this embodiment of this application includes two flexible circuit boards which are detachably connected. One flexible circuit board is arranged on a rear side of the battery and is connected to the USB interface, and the other flexible circuit board is arranged on a front side of the battery and is connected to the mainboard. When the USB interface needs to be detached, the first flexible circuit board can be seen by opening a cover plate on a rear side of the electronic device. Because the first flexible circuit board is detachably connected to the second flexible circuit board, the connection between the first flexible circuit board and the second flexible circuit board may be conveniently released, so that the first flexible circuit board is removed, and then subsequent processing is performed on the USB interface. In this way, there is no need to detach the battery, and steps of detaching the USB interface are simplified, so that the detaching complexity is reduced and there is no need to reinstall the battery, thereby reducing assembly difficulty and repair costs.

In a possible implementation of the first aspect, the second end of the first flexible circuit board is connected to the first end of the second flexible circuit board by using a board-to-board connector.

The board-to-board connector may be configured to connect different circuit boards together. In this way, electrical connection between the first flexible circuit board and the second flexible circuit board may be implemented.

In a possible implementation of the first aspect, the board-to-board connector includes a first connecting base and a second connecting base, where the first connecting base is arranged at the second end of the first flexible circuit board, and the second connecting base is arranged at the first end of the second flexible circuit board.

In a possible implementation of the first aspect, the first connecting base is a female base, and the second connecting base is a male base.

It may be understood that, in another possible implementation, the first connecting base may alternatively be a male base, and correspondingly, the second connecting base may alternatively be a female base. By snap-fitting the first connecting base and the second connecting base, electrical connection between the first flexible circuit board and the second flexible circuit board may be implemented. When the USB interface needs to be detached, the snap-fit between the first flexible circuit board and the second flexible circuit board which are connected to the USB interface only needs to be released.

In a possible implementation of the first aspect, a length direction of the board-to-board connector is arranged along a width direction of the electronic device, and a width direction of the board-to-board connector is arranged along a length direction of the electronic device; or a length direction of the board-to-board connector is arranged along a length direction of the electronic device, and a width direction of the board-to-board connector is arranged along a width direction of the electronic device.

It may be understood that there are many functional components for implementing various electronic functions in the electronic device, and an arrangement manner of the board-to-board connector may be adjusted according to an actual internal component layout of the electronic device. For example, the board-to-board connector may be arranged along the length direction of the electronic device, that is, may be arranged in a transverse direction, or may be arranged along the width direction of the electronic device, that is, may be arranged in a vertical direction.

In a possible implementation of the first aspect, the first flexible circuit board are in any one of the following shapes: a Π shape, a semi-circle shape, and an arch shape.

It may be understood that if the USB interface at one end of the first flexible circuit board and the board-to-board connector at the other end of the first flexible circuit board are arranged in a same direction, for example, are sequentially arranged along the width direction of the electronic device, the first flexible circuit board may be in any one of the foregoing Π shape, semi-circular shape, and arch shape. In another possible implementation, if the USB interface and the board-to-board connector are arranged in different directions, the first flexible circuit board may be in another shape such as a long strip.

In a possible implementation of the first aspect, a thickness of the first flexible circuit board ranges from 0.05 mm to 0.3 mm.

The thickness of the first flexible circuit board may be dynamically adjusted according to an actual internal space of the electronic device.

According to a second aspect, an embodiment of this application provides an electronic device, including the flexible printed circuit, the interface, the mainboard, the battery and the screen in the first aspect.

In a possible implementation of the first aspect, the electronic device further includes a printed circuit board, where the mainboard is arranged on one side of the battery along a length direction of the electronic device, and the printed circuit board is arranged on the other side of the battery along the length direction.

It may be understood that the printed circuit board may be configured to carry some functional components of the electronic device, which includes, but is not limited to, a USB interface and a board-to-board connector. The printed circuit board may be electrically connected to the mainboard by using a first flexible circuit board and a second flexible circuit board, to transmit an electrical signal.

In a possible implementation of the first aspect, the electronic device further includes a board-to-board connector, where the board-to-board connector and the interface are sequentially arranged on the printed circuit board along a width direction of the electronic device.

As described above, an arrangement manner of the board-to-board connector may be adjusted according to an actual internal component layout of the electronic device, which are not described herein again.

In a possible implementation of the first aspect, the electronic device further includes a battery cover plate, where the battery cover plate and the first flexible circuit board are arranged on a same side of the battery, and the first flexible circuit board is arranged between the battery cover plate and the battery; and the battery cover plate includes a first thinning region corresponding to the first flexible circuit board and a second thinning region configured to form identification information of the electronic device, where the first thinning region and the second thinning region do not overlap.

It may be understood that the battery cover plate is arranged on a rear side of the battery. The first flexible circuit board is arranged between the battery and the battery cover plate. Generally, the second thinning region which is used to form the identification information of the electronic device is arranged on the battery cover plate, where the identification information includes, but is not limited to, text or a pattern. However, because the first flexible circuit board has a specific thickness, to reserve a specific space for arranging the first flexible circuit board, a first thinning region for accommodating the first flexible circuit board is arranged on the battery cover plate. The first thinning region and the second thinning region do not overlap, to avoid a decrease in rigidity of the battery cover plate due to excessive thinning, thereby avoiding that the battery cover plate breaks.

### BRIEF DESCRIPTION OF DRAWINGS

FIG. 1 is a schematic diagram of an appearance of an electronic device according to an embodiment of this application;
FIG. 2 is a schematic exploded view of a partial internal structure of an electronic device according to an embodiment of this application;
FIG. 3 is a rear view of a partial internal structure of an electronic device according to an embodiment of this application;
FIG. 4 is a side view of a partial internal structure of an electronic device according to an embodiment of this application;
FIG. 5 is a schematic exploded view of a partial internal structure of another electronic device according to an embodiment of this application;
FIG. 6 is a schematic diagram of a first flexible circuit board according to an embodiment of this application;
FIG. 7 is a schematic diagram of a second flexible circuit board according to an embodiment of this application;
FIG. 8 is a simple schematic diagram of an internal structure of an electronic device according to an embodiment of this application;
FIG. 9 is a schematic exploded view of a partial structure of an electronic device according to an embodiment of this application; and
FIG. 10 is a schematic diagram of a battery cover plate according to an embodiment of this application.

### DESCRIPTION OF EMBODIMENTS

Illustrative embodiments of this application include but are not limited to a flexible printed circuit and an electronic device. The following describes embodiments of this application with reference to the accompanying drawings in embodiments of this application.

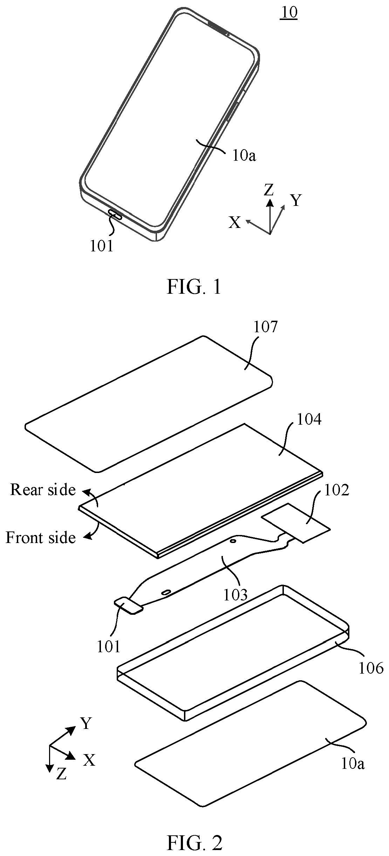

As described above, in an electronic device, a USB interface needs to be electrically connected to a mainboard by using a flexible printed circuit. Referring to FIG. 1 and FIG. 2, FIG. 1 is a schematic diagram of an appearance of an electronic device 10 according to an embodiment of this application, and FIG. 2 is a schematic exploded view of a partial internal structure of an electronic device 10 in some technical solutions.

In the embodiments of this application, a cellphone is used as an example of the electronic device 10. In another embodiment, the electronic device 10 may be a notebook computer, a tablet, a large-screen device, an in-vehicle device, a wearable device (such as a watch, smart glasses, or a helmet), an augmented reality (augmented reality, AR)/virtual reality (virtual reality, VR) device, a personal digital assistant (personal digital assistant, PDA), or the like. This is not limited in this application.

In the accompanying drawings of this specification, an X direction is a width direction of the electronic device, a Y direction is a length direction of the electronic device, and a Z direction is a thickness direction of the electronic device. Any two of the X direction, the Y direction, and the Z direction may be perpendicular.

It should be noted that, orientation words such as "top", "bottom", "left", "right", "front", and "rear" used in the embodiments of this application to describe the electronic device 10 are mainly described based on a display orientation of the electronic device 10 in FIG. 1, with "top" or "upper" facing a positive direction of a Y axis, "bottom" or "lower" facing a negative direction of the Y axis, "left" facing a positive direction of an X axis, "right" facing a negative direction of the X axis, "front" facing a positive direction of a Z axis, and "rear" facing a negative direction of the Z axis. This does not constitute a limitation on an orientation of the electronic device 10 in an actual application scenario.

As shown in FIG. 1 and FIG. 2, the electronic device 10 includes a screen 10a, a USB interface 101, a mainboard 102, a flexible printed circuit 103, a battery 104, a middle frame 106, and a battery cover plate 107. The screen 10a is configured to display text, an image, a video, and the like. The screen 10a may be any one of display screens, including a liquid crystal display (liquid crystal display, LCD), an organic light-emitting diode (organic light-emitting diode, OLED), and an active-matrix organic light-emitting diode (active-matrix organic light-emitting diode, AMOLED)

The USB interface 101 is an interface conforming to a USB standard specification, and may be specifically a Mini USB interface, a Micro USB interface, a USB Type C interface, or the like. The USB interface 101 may be configured to connect to a charger to charge the battery 104, or may be configured to transmit data between the electronic device 10 and a peripheral device, or may be configured to connect to a headset to play audio by using the headset.

The flexible printed circuit 103 has characteristics of being freely bent, folded and twisted, and may be made by using polyimide or a polyester film as a base material. The flexible printed circuit 103 is configured to connect to the USB interface 101 and the mainboard 102. Specifically, one end of the flexible printed circuit 103 is welded to the USB interface 101, and the other end is connected to a board-to-board connector (board-to-board connector) on the mainboard 102, to implement electrical connection between the USB interface 101 and the mainboard 102 by using the flexible printed circuit 103.

A processor (not shown in the figures) is arranged on the mainboard 102. After the USB interface 101 is electrically connected to the mainboard 102, the processor may be configured to process transmission data between the USB interface 101 and the peripheral device, or may be configured to control a charging process of the USB interface 101, or may be configured to control audio output of the USB interface 101.

In some embodiments, components such as a memory and a communication module may be further arranged on the mainboard 102. The memory and the communication module are respectively electrically connected to the processor. The memory is configured to store instructions and data. The communication module may implement wireless communication of a cellphone, such as 3G/4G/5G. The communication module may implement wireless communication of the electronic device 10, such as a wireless local area network (wireless local area network, WLAN), blue tooth (blue tooth, BT), and near field communication (near field communication, NFC).

It should be noted that, the components on the mainboard 102 are not limited to the foregoing descriptions, and electronic components implementing other performance of the electronic device 10 may also be arranged on the mainboard, which are not listed one by one herein.

The middle frame 106 is an important component connecting parts of the electronic device 10. The middle frame 106 may be made of a metal material or a plastic material. An appearance of the middle frame is a rectangular shape, and an internal structure of the middle frame is a recess structure, to facilitate installation of various components.

It may be understood that the USB interface in the electronic device may be fixedly connected to the middle frame by using a printed circuit board, or may be directly fixedly connected to the middle frame without a printed circuit board. In this application, only an example in which the USB interface is fixedly connected to the middle frame by using the printed circuit board is used, but this application is not limited thereto.

The battery cover plate 107 is installed on a rear side of the battery 104, and is configured to protect the electronic device 10. The battery cover plate 107 is usually made of a material such as glass, plastic, metal, or ceramic.

It should be noted that, in FIG. 2, arrangement positions of components, including the USB interface 101, the mainboard 102, the flexible printed circuit 103, the battery 104, the middle frame 106 and the battery cover plate 107, are only an example, which do not form a limitation on the arrangement positions of the components in an actual application scenario. For example, the mainboard 102 may be arranged at a top portion of the electronic device 10, or may be arranged on the left of the battery 104 in the electronic device 10.

In some embodiments, because other functional components such as a wireless charging coil and an NFC coil of the electronic device 10 need to be arranged on one side (which is used as a rear side of the battery 104) of the battery 104 facing away from the screen 10a of the electronic device 10, the rear side of the battery 104 does not have an enough cabling space to accommodate the flexible printed circuit 103. Therefore, the flexible printed circuit 103 is arranged only on one side (which is used as a front side of the battery 104) of the battery 104 facing the screen 10a. If the USB interface 101 needs to be detached and repaired, the battery cover plate on a rear side of the electronic device 10 needs to be opened first. The flexible printed circuit 103 can be seen after the battery 104 is detached, then the flexible printed circuit 103 is removed from the mainboard 102, and the USB interface 101 can be repaired finally. It can be seen that due to the structure and the arrangement manner of the flexible printed circuit 103, complex detaching of the USB interface 101 is caused, and the battery 104 needs to be reinstalled, increasing assembly difficulty.

In view of this, the embodiments of this application provide a flexible printed circuit. The flexible printed circuit includes two flexible circuit boards which are detachably connected. One flexible circuit board is arranged on the rear side of the battery and is connected to the USB interface, and the other flexible circuit board is arranged on the front side of the battery and is connected to the mainboard. In this way, when the USB interface needs to be detached, the flexible circuit board connected to the USB interface can be seen by opening the battery cover plate on the rear side of the electronic device, and subsequent processing can be performed on the USB interface after the flexible circuit board is removed.

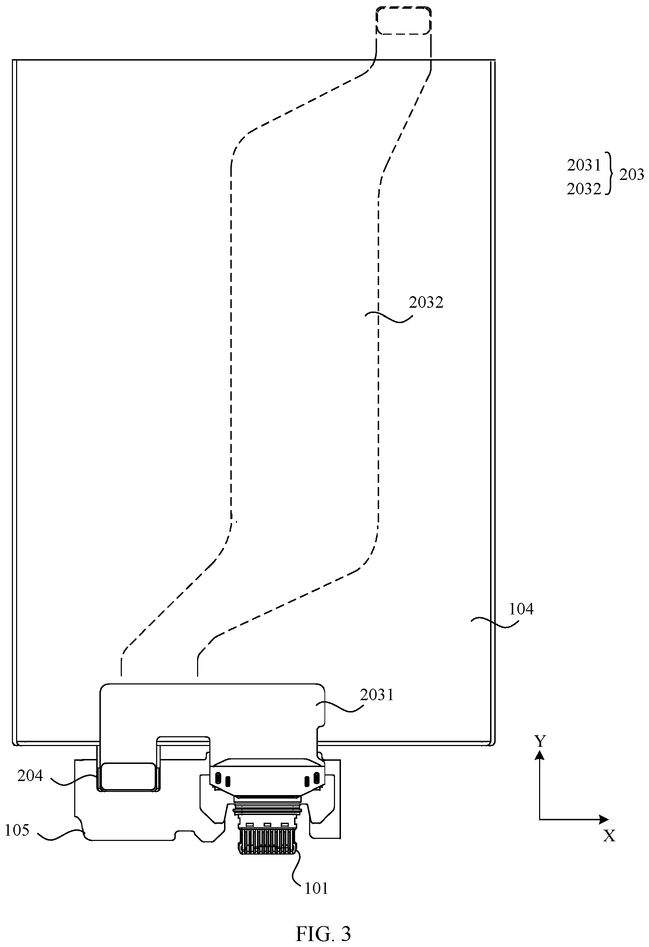

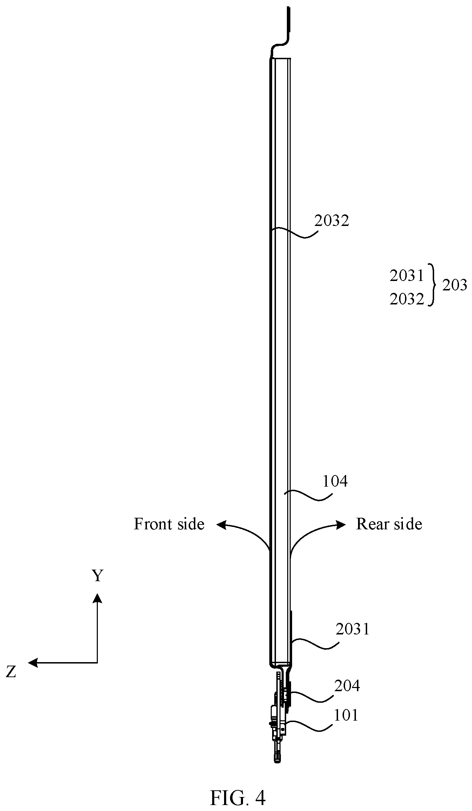

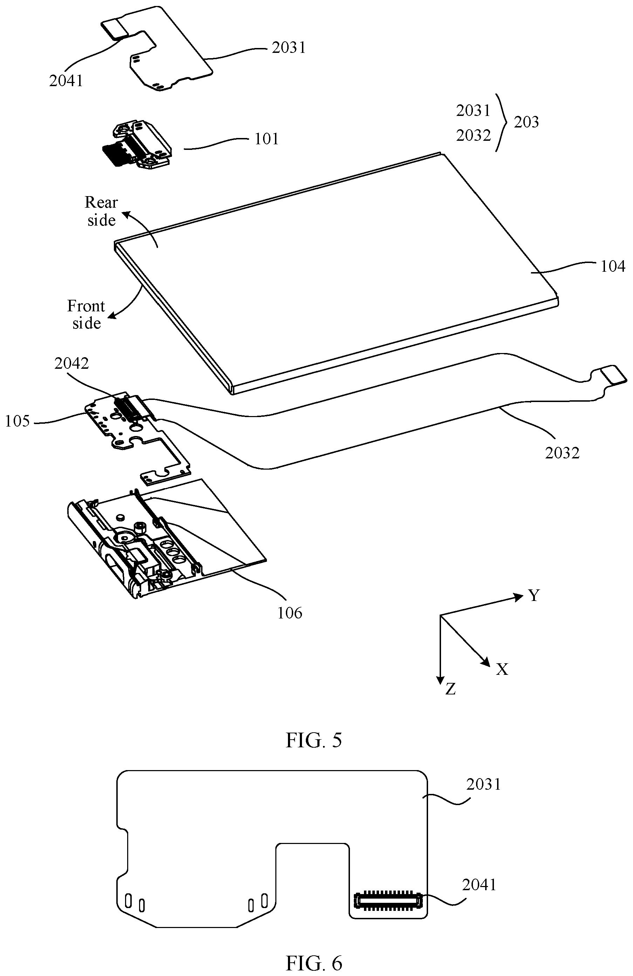

Specifically, as shown in FIG. 3 to FIG. 5, the embodiments of this application provide a flexible printed circuit 203, configured to connect to a USB interface 101 and a mainboard 102 in an electronic device 10. FIG. 3 is a rear view of a partial internal structure of the electronic device 10 according to an embodiment of this application. FIG. 4 is a side view of a partial internal structure of the electronic device 10 according to an embodiment of this application. FIG. 5 is a schematic exploded view of a partial internal structure of the electronic device 10 according to an embodiment of this application.

As shown in FIG. 3 to FIG. 5, the flexible printed circuit 203 includes a first flexible circuit board 2031 and a second flexible circuit board 2032. One end of the first flexible circuit board 2031 is connected to the USB interface 101, the other end of the first flexible circuit board 2031 is detachably connected to one end of the second flexible circuit board 2032 by using a board-to-board connector (which is referred to as a B2B connector for short below) 204, and the other end of the second flexible circuit board 2032 is connected to the mainboard 102 (not shown in the figures). Further, the first flexible circuit board 2031 is arranged on a rear side of a battery 104, and the second flexible circuit board 2032 is arranged on a front side of the battery 104. In this way, the USB interface 101 is transferred to the second flexible circuit board 2032 by using the first flexible circuit board 2031, to implement electrical connection to the mainboard 102. The first flexible circuit board 2031 may be arranged to be small, so that the first flexible circuit board 2031 only needs to occupy a relatively small cabling space on the rear side of the battery 104. When the USB interface 101 needs to be detached, the first flexible circuit board 2031 can be seen by opening a cover plate on a rear side of the electronic device 10. Because the first flexible circuit board 2031 is detachably connected to the second flexible circuit board 2032 by using the B2B connector 204, the connection between the first flexible circuit board 2031 and the second flexible circuit board 2032 may be conveniently released, to remove the first flexible circuit board 2031, and then subsequent processing is performed on the USB interface 101. In this way, there is no need to detach the battery 104, and steps of detaching the USB interface 101 are simplified, so that the detaching complexity is reduced and there is no need to reinstall the battery 104, thereby reducing assembly difficulty and repair costs.

In some embodiments, as shown in FIG. 3 and FIG. 5, the electronic device 10 further includes a printed circuit board 105. The printed circuit board 105 may be arranged at a bottom portion of the electronic device 10. The printed circuit board 105 is configured to carry other components such as the USB interface 101 at the bottom portion. A middle frame 106 is connected to the printed circuit board 105, and is configured to carry the entire printed circuit board 105. It should be noted that in different electronic devices, the printed circuit board for carrying the USB interface may be located at any position of the electronic device, which is not limited in this application.

As shown in FIG. 3, the printed circuit board 105 is configured to carry the USB interface 101 and the B2B connector 204. The B2B connector 204 and the USB interface 101 may be arranged on the printed circuit board 105 at an interval along an X direction. it should be noted that the printed circuit board 105 is a circuit board originally arranged in the electronic device 10, which is configured to carry other components such as the USB interface 101 at the bottom portion. In an actual application, in different electronic devices, the printed circuit board for carrying the USB interface may be located at any position of the electronic device.

**In** addition, in consideration of various internal structure design of the electronic device, a relative position between the B2B connector 204 and the USB interface 101 is not limited in this application. The arrangement manner in FIG. 3 is merely an example for ease of description below.

For the electronic device 10 shown in FIG. 1, to reduce a thickness of the electronic device 10 in a Z direction, the printed circuit board 105 and the mainboard 102 are respectively arranged on two sides of the battery 104 along a Y direction. For example, the printed circuit board 105 is arranged on one side of the battery 104 close to a bottom portion of the electronic device 10, and the mainboard 102 is arranged on one side of the battery 104 close to a top portion of the electronic device 10.

As described above, the first flexible circuit board 2031 and the second flexible circuit board 2032 are connected by using the B2B connector 204. The B2B connector 204 may include a first connecting base 2041 and a second connecting base 2042. The first connecting base 2041 and the second connecting base 2042 may be respectively arranged on an end portion of the first flexible circuit board 2031 and an end portion of the second flexible circuit board 2032. In this way, by snap-fitting the first connecting base 2041 and the second connecting base 2042, connection between the first flexible circuit board 2031 and the second flexible circuit board 2032 may be implemented.

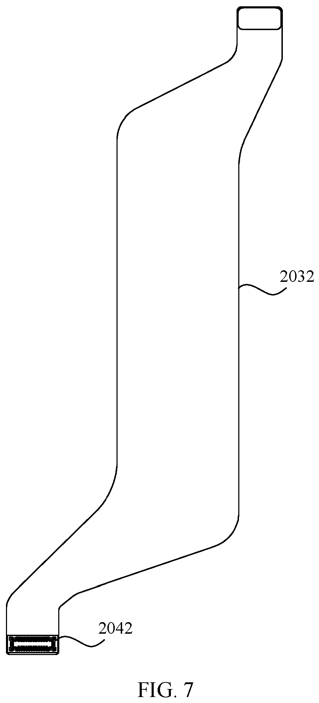

In some embodiments, as shown in FIG. 6 and FIG. 7, FIG. 6 is a schematic diagram of a first flexible circuit board 2031 according to an embodiment of this application, and FIG. 7 is a schematic diagram of a second flexible circuit board 2032 according to an embodiment of this application. A first connecting base 2041 is arranged on an end of the first flexible circuit board 2031, and a second connecting base 2042 is arranged on an end of the second flexible circuit board 2032. Herein, for example, the first connecting base 2041 is a female base, and the second connecting base 2042 is a male base. In another example, the first connecting base 2041 may alternatively be a male base, and correspondingly, the second connecting base 2042 may be a female base.

Generally, an appearance of the B2B connector 204 is a rectangular shape. Therefore, in some embodiments, as shown in FIG. 3, a length direction of the B2B connector 204 is arranged along the X direction, and a width direction of the B2B connector 204 is arranged along the Y direction. That is, the B2B connector 204 is arranged in a transverse direction. In another embodiment of this application, the length direction of the B2B connector 204 may alternatively be arranged along the Y direction, and the width direction is arranged along the X direction. That is, the B2B connector 204 is arranged in a vertical direction. A specific arrangement manner of the B2B connector 204 may be adjusted according to an actual internal space of the electronic device, which is not limited in this application.

In another embodiment of this application, in addition to the foregoing B2B connector 204, another connector may further be used to implement detachable connection between the first flexible circuit board 2031 and the second flexible circuit board 2032.

As described above, the USB interface 101 and the B2B connector 204 may be arranged on the printed circuit board 105 at an interval along the X direction. Therefore, in some embodiments, the first flexible circuit board (2031) are in any one of the following shapes: a Π shape, a semi-circle shape, and an arch shape. As shown in FIG. 3, FIG. 5, and FIG. 6, the first flexible circuit boards 2031 are in the shape of Π.

In addition, as described above, the mainboard 102 is arranged on the side of the battery 104 close to the top portion of the electronic device 10, and the B2B connector 204 is arranged on the side of the battery 104 close to the bottom portion of the electronic device 10. Therefore, in some embodiments, the second flexible circuit board 2032 may be in the shape of a long strip.

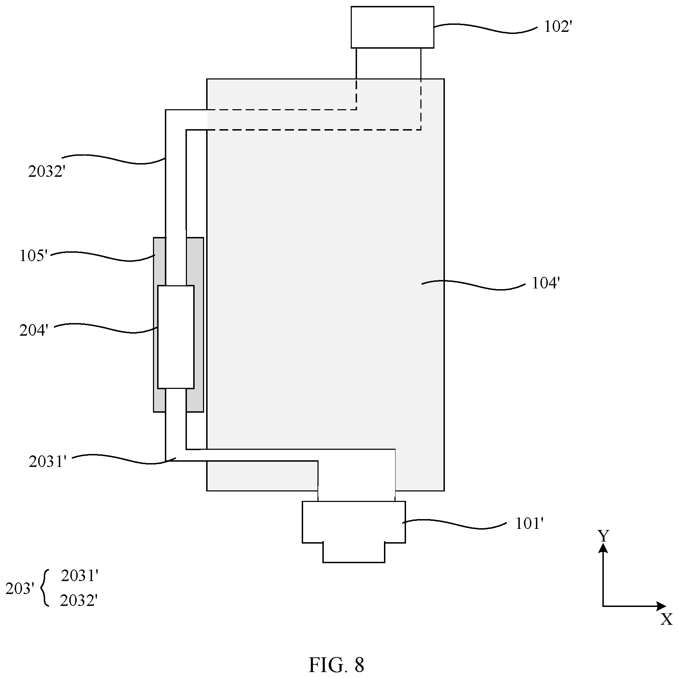

In consideration of various internal structure design of the electronic device, in an actual application, to adapt to various internal structures of the electronic device, the shape of the first flexible circuit board 2031 and the shape of the second flexible circuit board 2032 may be adjusted according to an actual internal structure of the electronic device. Another possible flexible printed circuit 203' is described below with reference to FIG. 8. In the flexible printed circuit 203', a shape of a first flexible circuit board 2031' and a shape of a second flexible circuit board 2032' may be adjusted according to an internal structure of an electronic device 10'.

FIG. 8 is a simple schematic diagram of an internal structure of the electronic device 10' according to an embodiment of this application.

As shown in FIG. 8, in the electronic device 10', a USB interface 101' and a mainboard 102' are respectively arranged on two sides of a battery 104', the mainboard 102' is arranged on a top portion of the battery 104' close to the electronic device 10 ', and the USB interface 101' is arranged on a bottom portion of the battery 104' close to the electronic device 10'.

The electronic device 10' differs from the electronic device 10 in that a printed circuit board 105' for carrying a component is arranged on a right side (a left side from a viewing angle of FIG. 8) of the battery 104', and a B2B connector 204' may be arranged on the printed circuit board 105', to implement detachable connection between the first flexible circuit board 2031' and the second flexible circuit board 2032' by using the B2B connector 204'. Referring to the first flexible circuit board 2031, the first flexible circuit board 2031' is arranged on a rear side of the battery 104', and referring to the second flexible circuit board 2032, the second flexible circuit board 2032' is arranged on a front side of the battery 104 '. In FIG. 8, a part of the second flexible circuit board 2032' which is covered by the battery 104' is shown by using a dashed line.

It can be seen from FIG. 8 that the B2B connector 204' is arranged on the right side of the battery 104', so that a shape of the first flexible circuit board 2031' and a shape of the second flexible circuit board 2032' may be adjusted to a long strip shape having a bend, or may be an arc shape.

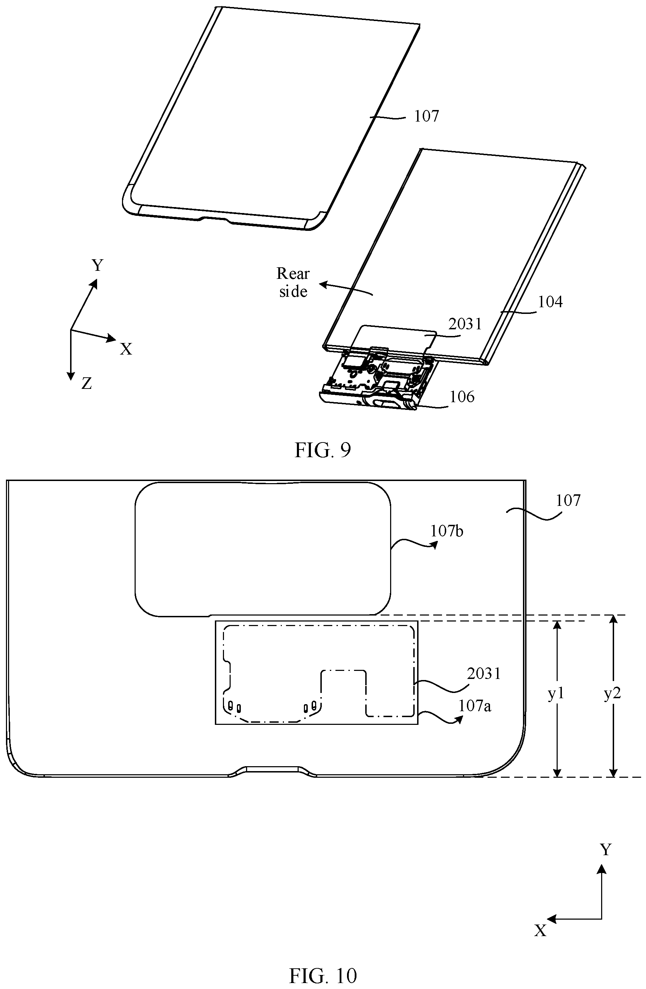

Referring to FIG. 9, FIG. 9 is a schematic exploded view of a partial structure of an electronic device 10 according to an embodiment of this application. It should be noted that FIG. 9 shows only a part of battery cover plate 107 in a Y direction. It may be understood that the battery cover plate 107 is arranged on a rear side of a battery 104. The first flexible circuit board 2031 is arranged between the battery 104 and the battery cover plate 107.

Referring to FIG. 10, FIG. 10 is a schematic diagram of a battery cover plate 107 according to an embodiment of this application. To facilitate observation, a first flexible circuit board 2031 is shown by using a dash-dot line. As shown in FIG. 10, the battery cover plate 107 includes a first thinning region 107a corresponding to the first flexible circuit board 2031. The first thinning region 107a is used to accommodate the first flexible circuit board 2031 after being thinned. A thinning thickness of the first thinning region 107a may be determined according to an actual thickness of the first flexible circuit board 2031. For example, the thickness of the first flexible circuit board 2031 ranges from 0.05 mm to 0.3 mm such as 0.05 mm, 0.08 mm, 0.09 mm, 0.1 mm, 0.2 mm, 0.3 mm, or the like. In this way, the region on the battery cover plate 107 that corresponds to the first flexible circuit board 2031 is thinned, to avoid an increase in a thickness of the electronic device 10 in a Z direction caused by the first flexible circuit board 2031.

In some embodiments, the battery cover plate 107 further includes a second thinning region 107b. The second thinning region 107b is used to be thinned and etched to form identification information of the electronic device 10. The identification information includes, but is not limited to, text or a pattern. The first thinning region 107a and the second thinning region 107b do not overlap, to avoid a decrease in rigidity of the battery cover plate 107 due to excessive thinning, thereby avoiding break of the battery cover plate. Specifically, a distance y1 from an upper edge of the first thinning region 107a to a bottom of the electronic device 10 is less than a distance y2 from a lower edge of the second thinning region 107b to the bottom of the electronic device 10. That is, a size of the first flexible circuit board 2031 in a Y direction needs to be determined according to a position of the second thinning region 107b on the battery cover plate 107.

It should be noted that in the examples and specification of this application, the relational terms such as first and second are used only to differentiate an entity or operation from another entity or operation, and do not require or imply any actual relationship or sequence between these entities or operations. Moreover, the terms "include", "comprise", and any variation thereof are intended to cover non-exclusive inclusion. Therefore, in the context of a process, a method, an object, or a device that includes a series of elements, the process, method, object, or device not only includes such elements, but also includes other elements not specified expressly, or may include inherent elements of the process, method, object, or device. Without any further limitation, an element defined by the phrase "including one" does not exclude existence of other same elements in the process, the method, the article, or the device that includes the elements.

Although this application is shown and described with reference to some preferred embodiments of this application, a person of ordinary skill in the art should understand that various changes in form and details may be made therein without departing from the scope of this application.

## Claims

1. A flexible printed circuit, comprising a first flexible circuit board (2031) and a second flexible circuit board (2032), wherein
a first end of the first flexible circuit board (2031) is configured to connect to a universal serial bus interface (101) of an electronic device (10) in which the flexible printed circuit (203) is located, wherein the first flexible circuit board (2031) is arranged on one side of a battery (104) of the electronic device (10) facing away from a screen (10a) of the electronic device (10), and
a second end of the first flexible circuit board (2031) is detachably connected to a first end of the second flexible circuit board (2032); and
a second end of the second flexible circuit board (2032) is connected to a mainboard (102) of the electronic device (10), wherein the second flexible circuit board (2032) is arranged on one side of the battery (104) facing the screen (10a).

2. The flexible printed circuit according to claim 1, wherein the second end of the first flexible circuit board (2031) is connected to the first end of the second flexible circuit board (2032) by using a board-to-board connector (204).

3. The flexible printed circuit according to claim 2, wherein the board-to-board connector (204) comprises a first connecting base (2041) and a second connecting base (2042), wherein
the first connecting base (2041) is arranged at the second end of the first flexible circuit board (2031), and the second connecting base (2042) is arranged at the first end of the second flexible circuit board (2032).

4. The flexible printed circuit according to claim 3, wherein the first connecting base (2041) is a female base, and the second connecting base (2042) is a male base.

5. The flexible printed circuit according to claim 2, wherein a length direction of the board-to-board connector (204) is arranged along a width direction of the electronic device (10), and a width direction of the board-to-board connector (204) is arranged along a length direction of the electronic device (10); or
a length direction of the board-to-board connector (204) is arranged along a length direction of the electronic device (10), and a width direction of the board-to-board connector (204) is arranged along a width direction of the electronic device (10).

6. The flexible printed circuit according to any one of claims 1 to 5, wherein the first flexible circuit board (2031) are in any one of the following shapes: a Π shape, a semi-circle shape, and an arch shape.

7. The flexible printed circuit according to claim 6, wherein a thickness of the first flexible circuit board (2031) ranges from 0.05 mm to 0.3 mm.

8. An electronic device, comprising the flexible printed circuit (203), the interface (101), the mainboard (102), the battery (104), and the screen (10a) according to any one of claims 1 to 7.

9. The electronic device according to claim 8, wherein the electronic device further comprises a printed circuit board (105), wherein
the mainboard (102) is arranged on one side of the battery (104) along a length direction of the electronic device, and the printed circuit board (105) is arranged on the other side of the battery (104) along the length direction.

10. The electronic device according to claim 9, wherein the electronic device further comprises a board-to-board connector (204), wherein
the board-to-board connector (204) and the interface (101) are sequentially arranged on the printed circuit board (105) along a width direction of the electronic device.

11. The electronic device according to claim 8, wherein the electronic device further comprises a battery cover plate (107), wherein the battery cover plate (107) and the first flexible circuit board (2031) are arranged on a same side of the battery (104), and the first flexible circuit board (2031) is arranged between the battery cover plate (107) and the battery (104); and
the battery cover plate (107) comprises a first thinning region (107a) corresponding to the first flexible circuit board (2031), and a second thinning region (107b) used to form identification information of the electronic device, wherein
the first thinning region (107a) and the second thinning region (107b) do not overlap.
